(19) Europäisches Patentamt
European Patent Office
Office européen des brevets

(11) **EP 1 615 271 B1**

(12) **FASCICULE DE BREVET EUROPEEN**

(45) Date de publication et mention
de la délivrance du brevet:
**23.06.2010 Bulletin 2010/25**

(51) Int Cl.:
***H01L 29/78*** *(2006.01)*

(21) Numéro de dépôt: **05106047.3**

(22) Date de dépôt: **04.07.2005**

(54) **Procédé pour contraindre un motif mince**

Verfahren zum Verspannen einer Dünnschichtstruktur

Method of straining a thin film pattern

(84) Etats contractants désignés:
**DE FR GB IT**

(30) Priorité: **05.07.2004 FR 0451440**

(43) Date de publication de la demande:
**11.01.2006 Bulletin 2006/02**

(73) Titulaire: **Commissariat à l'Énergie Atomique
et aux Énergies Alternatives
75015 Paris (FR)**

(72) Inventeurs:
• **BARBE, Jean-Charles
38100, GRENOBLE (FR)**
• **ERNST, Thomas
38140, CHARNECLES (FR)**

(74) Mandataire: **Poulin, Gérard et al
Brevalex
3, rue du Docteur Lancereaux
75008 Paris (FR)**

(56) Documents cités:
**EP-A- 1 231 643      US-A- 5 532 510
US-A1- 2003 155 592   US-A1- 2005 106 792
US-B2- 6 563 152**

• **RAYSSAC O ET AL: "From SOI to SOIM
technology: Application for specific
semiconductor processes" SILICON-ON-
INSULATOR TECHNOLOGY AND DEVICES X.
PROCEEDINGS OF THE TENTH INTERNATIONAL
SYMPOSIUM (ELECTROCHEMICAL SOCIETY
PROCEEDINGS VOL.2001-3) ELECTROCHEM.
SOC PENNINGTON, NJ, USA, 2001, pages 39-44,
XP008043050 ISBN: 1-56677-309-1**
• **RIM K ET AL: "Fabrication and mobility
characteristics of ultra-thin strained si directly on
insulator (SSDOI) MOSFETs" INTERNATIONAL
ELECTRON DEVICES MEETING 2003. IEDM.
TECHNICAL DIGEST. WASHINGTON, DC, DEC 8
- 10, 2003, NEW YORK, NY : IEEE, US, 8 décembre
2003 (2003-12-08), pages 49-52, XP010683956
ISBN: 0-7803-7872-5**

**Description**

**DOMAINE TECHNIQUE ET ART ANTÉRIEUR**

L'invention concerne le domaine des semiconducteurs et de la micro - électronique.

Les circuits intégrés sont habituellement construits sur des substrats en silicium. Ces substrats peuvent être constitués d'une ou de plusieurs couches de natures différentes (par exemple le Silicium sur Isolant dit SOI) mais la couche dans laquelle le transport électronique se fait est toujours formée d'un matériau semi-conducteur.

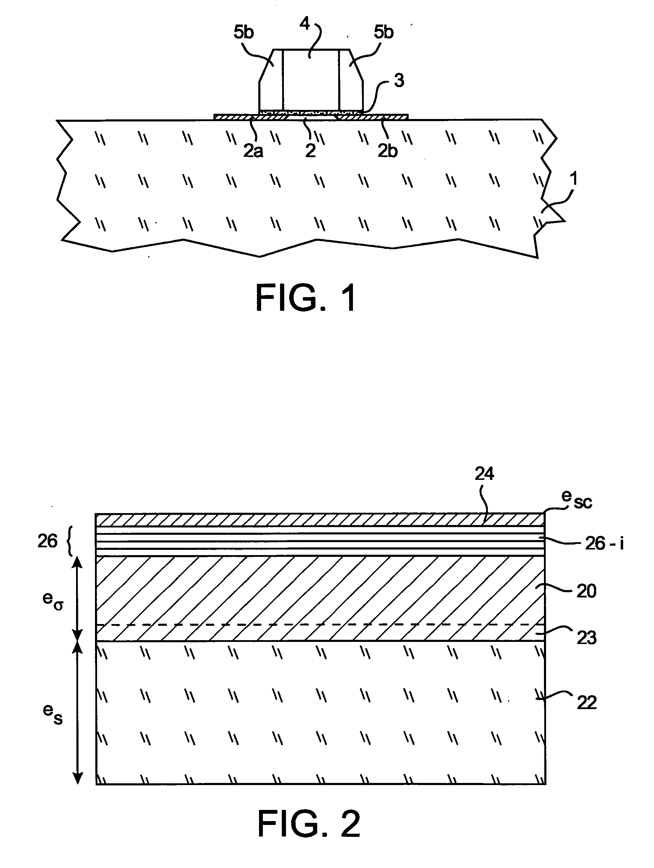

Comme l'illustre le schéma de la figure 1, ces circuits intégrés sont formés, au niveau le plus proche du substrat (zone indexée 1 sur la figure 1), de millions de transistors qui comprennent une grille 4 de quelques dizaines de nanomètres de large et d'un canal 2, situé sous la grille et séparé de celle-ci par un isolant électrique 3.

Les zones d'accès à cette zone de transport que constitue le canal sont appelées source et drain (zones respectivement 2a et 2b, hachurées, sur la figure 1).

De part et d'autre de la grille sont disposés les espaceurs (références 5a et 5b sur la figure 1).

La grille contrôle la quantité de porteurs dans le canal et donc le courant qui transite entre la source et le drain.

Le transistor est dit de type N si la conduction dans le canal est assurée par des électrons: les impuretés dans la source et le drain sont alors de type N (atomes donneurs d'électrons) et on parle alors de transistor NMOS.

Le transistor est dit de type P si la conduction dans le canal est assurée par des trous : les impuretés dans la source et le drain sont alors de type p (atomes accepteurs d'électrons) et on parle alors de transistor PMOS.

Un courant peut alors passer de la source au drain à travers le canal sous certaines conditions de polarisation entre la grille, la source et le drain.

Le document US 6,563,152 décrit un procédé permettant de contraindre la zone de transport dans un transistor.

La technique décrite dans ce document met en oeuvre plusieurs étapes technologiques, et notamment un ajout de matière pour venir contraindre a posteriori le canal d'un transistor de type MOS.

Le procédé mis en oeuvre enchaîne 3 étapes de gravure : les deux premières sont des gravures anisotropes et la seconde est une gravure isotrope. Comme illustré dans ce document, ces étapes permettent de mettre à nu la face arrière du canal. La cavité formée sous le canal est alors comblée par un matériau semi-conducteur ou isolant qui doit contraindre le canal, du fait d'une différence de paramètre de maille ou d'une différence de coefficient de dilatation par rapport au matériau semi-conducteur dont est constitué le canal, et qui contraint donc la couche dans laquelle les trois étapes de gravure sont réalisées.

Il se pose le problème de simplifier le procédé de réalisation d'un canal contraint, les étapes décrites dans le document précité étant complexes.

De plus la méthode proposée dans le brevet sus-cité présente une difficulté intrinsèque de mise en oeuvre: tant que le matériau qui comble la zone dégagée sous le canal est déposé en faible épaisseur devant la hauteur totale de l'empilement technologique préexistant à la surface du canal (cet empilement étant désigné par les références 12-14,22 et 26 sur la figure 3 du brevet sus-cité) le matériau déposé subit la rigidité élastique de cet empilement et ne le contraint que très faiblement. Il faut donc que la cavité dégagée soit grande devant la hauteur de l'empilement de grille, qui est typiquement de l'ordre de 100 nm, et cela doit être d'autant plus vrai que le matériau de remplissage a un faible module élastique.

Il se pose donc le problème de trouver un autre procédé permettant de contraindre un motif de faible épaisseur, et notamment d'un canal de transistor.

**EXPOSÉ DE L'INVENTION**

L'invention concerne un procédé permettant d'obtenir un motif mince contraint ou d'augmenter ou d'accroître la contrainte dans un tel motif, à partir d'un empilement initial comportant ladite couche mince et une couche précontrainte.

L'invention concerne un procédé permettant de contraindre ou de déformer un motif ou une couche mince, ou d'accroître ou d'augmenter une contrainte ou une déformation dans un motif ou une couche mince, à partir d'un empilement initial comportant ladite couche mince et une couche précontrainte, ce procédé comportant :

- une étape de relaxation de la contrainte initiale de la couche précontrainte par gravure sur une partie seulement de son épaisseur.

Un procédé selon l'invention permet de contraindre ou de déformer un motif ou une couche mince, ou d'accroître ou d'augmenter une contrainte ou une déformation dans un motif ou une couche mince, par transfert, dans ce motif ou dans cette couche mince, de la déformation (ou de la pré-contrainte) d'une couche précontrainte, située sous le motif et éventuellement sur un substrat.

L'invention concerne donc un procédé utilisant une couche pré-contrainte à la surface de laquelle on retrouve un film ou une couche ou un motif mince, par exemple en silicium ou en tout autre semiconducteur utilisé en microélectronique.

La couche contrainte, et donc le film mince que l'on trouve à la surface de la couche précontrainte, est gravée latéralement, de part et d'autre d'un motif défini dans ledit film mince, afin de lui permettre de se relaxer dans la direction perpendiculaire à la gravure et, ainsi, de contraindre le motif mince.

L'invention concerne donc un procédé permettant de contraindre un motif mince par transfert de la contrainte d'une couche sous-jacente vers le motif grâce à la gravure latérale en profondeur de la couche pré-contrainte, et d'éventuelles couches intermédiaires, par exemple à l'aplomb du motif, par gravure anisotrope ou isotrope.

La hauteur de gravure peut être optimisée afin d'utiliser la singularité géométrique qu'est le pied de la gravure pour dépasser la contrainte maximale calculée avec une hypothèse de comportement élastique linéaire.

Le contrôle de l'état de tension (respectivement de compression) d'un motif mince permet d'améliorer les performances d'un empilement ou d'un composant de type transistor NMOS (respectivement PMOS) en contraignant le canal dudit transistor.

Ce contrôle s'obtient en faisant varier la profondeur de gravure, l'épaisseur du film mince ou encore le rapport (épaisseur gravée)/(épaisseur du film).

Ce contrôle s'obtient aussi en contrôlant le niveau de contrainte initial de la couche pré-contrainte et la nature des matériaux, c'est-à-dire les propriétés élastiques (module de Young et coefficient de Poisson), des matériaux mis en jeux.

Ce procédé peut, entre autre, être mis à profit pour contraindre de façon contrôlée le canal d'un transistor afin d'y modifier les propriétés de transport électroniques.

La couche pré-contrainte peut être par exemple en $Si_3N_4$.

L'empilement initial peut en outre comporter une ou plusieurs couches intercalées entre le motif ou la couche mince, et la couche pré-contrainte.

La somme des épaisseurs des couches intercalées et de l'épaisseur du motif ou de la couche mince est de préférence faible devant l'épaisseur gravée de la couche pré-contrainte.

De préférence, la couche précontrainte du composant initial repose sur un substrat, par exemple comportant une ou plusieurs couches.

L'épaisseur de la couche précontrainte avant gravure est de préférence faible devant l'épaisseur du substrat.

Une couche tampon ou de tenue mécanique par exemple en $SiO_2$ peut être disposée entre la couche précontrainte et le substrat.

La gravure de la couche précontrainte conduit, dans cette couche précontrainte, à la formation de cavités latérales, qui peuvent être ensuite comblées par un matériau.

Ce matériau utilisé pour combler les cavités latérales peut présenter lui même un état de contrainte, intrinsèque ou, du fait d'une différence de coefficient de dilatation thermique entre ce matériau et le matériau constituant le motif mince, pouvant résulter de la gravure et de la relaxation de la couche pré-contrainte.

L'invention concerne également un procédé de formation d'un transistor, comportant un procédé pour contraindre une couche mince, tel que décrit ci-dessus, ainsi que la formation d'une grille, d'espaceurs et l'implantation ou la diffusion de zones d'accès, source et drain.

**BRÈVE DESCRIPTION DES DESSINS**

- La figure 1 est une vue schématique d'un transistor.
- La figure 2 représente un empilement technologique constituant un substrat de départ pour un procédé selon l'invention.
- Les figures 3A - 3C représentent des étapes d'un procédé selon l'invention.
- Les figures 4A et 4B représentent un état de contrainte d'un film semi-conducteur préparé selon l'invention.
- La figure 5 représente l'évolution du maximum de la composante σxx de la contrainte dans la couche semi-conductrice en fonction du rapport R1, égal à la largeur du motif divisée par son épaisseur $\left( R1 = \dfrac{L_{24}}{e_{24}} \right)$.

- Les figures 6A et 6B représentent respectivement l'évolution du champ de contrainte σxx et du maximum de la composante σxx du tenseur de contrainte, en fonction du rapport $R2 = \dfrac{L_{24}}{h_g}$ .

- Les figures 7A et 7B représentent un empilement obtenu respectivement après gravure isotrope et anisotrope.
- Les figures 8A à 8C représentent des étapes de réalisation d'un transistor, selon un procédé conforme à l'invention.

## EXPOSÉ DÉTAILLÉ DE MODES DE RÉALISATION PARTICULIERS

Un mode de réalisation de l'invention va être exposé en relation avec les figures 2 à 4.

Sur la figure 2, une couche pré-contrainte 20 d'épaisseur $e_\sigma$, repose sur la surface d'un substrat 22 d'épaisseur $e_s$.

Ce dernier est de préférence en silicium, mais il peut être en matériau quelconque. Il peut aussi comporter une ou plusieurs couches.

Ce substrat permet d'assurer une rigidité mécanique suffisante pour limiter la relaxation de la couche pré-contrainte 20 par une autre voie que la gravure.

La couche 20 est par exemple en un matériau amorphe, par exemple en nitrure de silicium Si3N4.

Elle peut aussi être cristalline. Dans ce cas, son état de pré-déformation peut avoir été obtenu par hétéro-épitaxie : on exploite alors la différence de paramètre de maille entre le substrat 22 et le matériau épitaxié à sa surface, l'épaisseur épitaxiée restant inférieure à l'épaisseur critique au-delà de laquelle le film 24 pourrait relaxer sa contrainte, de lui-même, par plastification (émission et glissement de dislocations). Cet état de déformation peut aussi avoir été obtenu par implantation de la couche pour obtenir une couche pré-déformée en compression, et donc un motif mince qui, après gravure, sera dans un état de tension. Si la couche est en silicium, on pourra par exemple implanter du germanium.

Cette couche précontrainte peut être isolante ou conductrice mais, pour des applications telles que le contrôle des propriétés de transport par déformation du canal d'un transistor MOS, elle est de préférence électriquement isolante (par exemple en Si3N4), afin de limiter les courants de fuite.

Une couche 23 tampon peut être déposée entre le substrat 22 et la couche 20, afin d'améliorer la tenue mécanique de l'empilement. Cette couche peut par exemple être en $SiO_2$.

Cette couche précontrainte 20 est enterrée sous une couche 24 d'un matériau semiconducteur d'épaisseur $e_{sc}$ dans laquelle le transport électronique se fera.

De préférence la pré-contrainte est bi-axiale dans un plan perpendiculaire à la surface du substrat 22 : les deux termes principaux du tenseur des contraintes contenus dans ce plan sont égaux et non nuls (strictement positifs ou strictement négatifs), le terme principal normal à la surface du substrat étant nul, ou du moins négligeable, devant les deux autres termes.

Une ou plusieurs couches 26 - 1, ...2 6 - i,... (l'ensemble de ces couches est désigné par la référence unique 26) dont les épaisseurs respectives seront notées e1, ...ei.... peuvent être interposées entre la couche pré-contrainte 20 et la couche semi-conductrice 24, d'épaisseur $e_{sc}$. Ces couches peuvent être cristallines ou amorphes, conductrices ou isolantes selon la fonction qu'elles remplissent (couche d'accrochage ou autre).

Un substrat tel que celui de la figure 2 peut être réalisé comme expliqué dans le document de O. RAYSSAC dans SOI Technology and Devices, Electro-Chemical Society Proceedings, Vol. 39 (2001).

De préférence, la somme des épaisseurs $e_i$, notée $\Sigma e_i$ par la suite, et de $e_{sc}$ (épaisseur de la couche 24) est faible devant $e_\sigma$ (épaisseur de la couche 20) et $e_\sigma$ est faible devant $e_s$ (épaisseur du substrat). Cette condition n'est pas nécessaire à la mise sous contrainte de la couche semi-conductrice mais elle permet d'optimiser le «transfert» de contrainte de la couche pré-contrainte 20 vers la couche semi-conductrice 24.

Par abus de langage, on parle de « transfert de contrainte » alors que ce qui est effectivement transmis du matériau pré-contraint 20 aux couches 24, 26 - i, déposées à sa surface est la déformation.

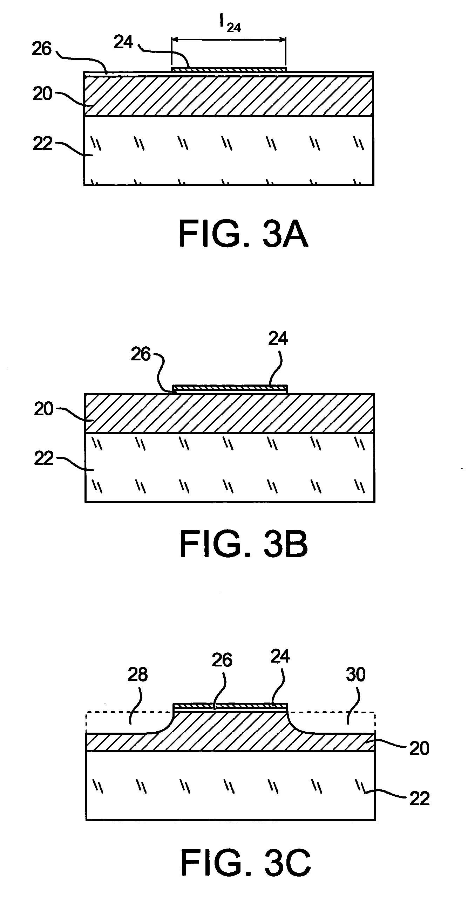

Les étapes suivantes d'un procédé selon l'invention vont être décrites en liaison avec les figures 3A - 3C. Sur ces figures 3A - 3C, des références identiques à celles de la figure 2 y représentent des éléments identiques ou similaires.

Le film mince semi-conducteur 24 est gravé pour définir la zone dans laquelle seront situés les sources, canal et drain du transistor.

On définit ainsi la largeur 124 du futur transistor comme l'illustre la figure 3A.

On grave, à la même côte, l'ensemble des films intermédiaires 26 entre le semi-conducteur 24 et la couche pré-contrainte 20 : cette gravure peut être effectuée séquentiellement, ou en une seule étape, en fonction de la nature des matériaux constituant cette partie de l'empilement. Cette étape est illustrée sur la figure 3B.

La couche pré-contrainte 20 est ensuite gravée de part et d'autre du motif formé par gravure des couches 26 et 24 (figure 3C).

Cette gravure peut se faire sur toute l'épaisseur de la couche pré-contrainte 20, mais peut aussi ne se faire

# EP 1 615 271 B1

que sur une partie de cette couche selon le niveau de contrainte désiré dans la couche semi-conductrice.

Cette étape de gravure permet d'autoriser une relaxation de la contrainte initiale de la couche pré-contrainte 20 et, ce faisant, de contraindre l'empilement 24, 26 qui se trouve à sa surface, y compris le film semi-conducteur 24 dans lequel le transport de porteurs se fera.

Cette étape est illustrée sur la figure 3C. Elle conduit à la formation de cavités latérales 28, 30 dans la couche 20.

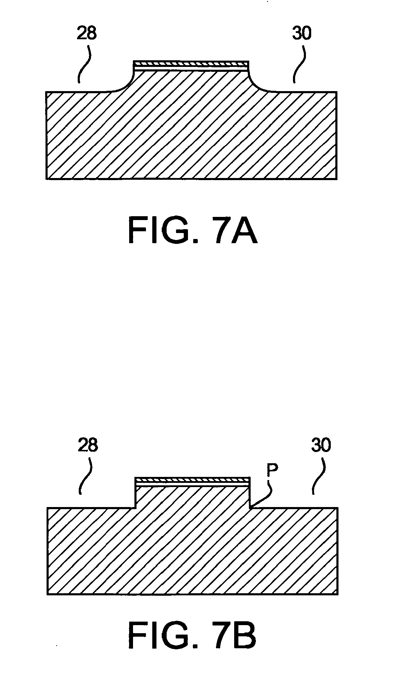

Les figures 7A et 7B représentent respectivement le résultat d'une gravure isotrope et celui d'une gravure anisotrope (qui permet d'obtenir des flancs verticaux).

Les cavités latérales 28,30 formées dans l'empilement peuvent ensuite être comblées, de préférence par un matériau isolant électriquement.

Ce matériau peut lui même être contraint intrinsèquement ou thermiquement.

Mais, de préférence, cet état de contrainte renforce l'état de contrainte imposé par la relaxation de la couche pré-contrainte 20 obtenue au cours de l'étape précédente : quelle que soit l'origine de cette contrainte (intrinsèque au procédé technologique ou induite par les écarts de coefficients de dilatation entre les différents matériaux en présence), pour un canal 24 en tension (respectivement en compression) cette contrainte des matériaux des cavités latérales est, elle-même, de préférence une contrainte de tension (respectivement de compression) pour renforcer la tension dans le canal 24 à la température de service.

Afin de quantifier l'influence des étapes de gravure, décrites ci-dessus, sur l'état de contrainte du motif mince semi-conducteur 24, des calculs numériques ont été effectués par outil de simulation CASTEM®, mettant en oeuvre la technique des « éléments finis ».

La structure initiale est celle de la figure 2, avec un substrat 22 en silicium, une couche précontrainte 20 en nitrure de silicium, une unique couche intermédiaire 26 en dioxyde de silicium, et une couche 24 de transport en silicium.

Pour les calculs de l'équilibre mécanique après gravure de la couche 20 de nitrure de silicium pré-contrainte, calculs dont les résultats sont présentés ci-dessous, les paramètres géométriques et les propriétés élastiques des matériaux de ces différentes couches sont ceux présentés dans le tableau I ci-dessous.

Ce calcul a été mené à température ambiante et seul la couche 20 de nitrure de silicium était initialement contrainte.

Tableau I

| Substrat 22: Silicium Si | |
| --- | --- |
| Module de Young : | 170 GPa |
| Coefficient de Poisson : | 0.278 |
| Epaisseur : | 30 μm |
| **Couche pré-contrainte 20 : nitrure de silicium Si3N4** | |
| Module de Young : | 380 GPa |
| Coefficient de Poisson : | 0.33 |
| Epaisseur : | 1.5 μm |
| Largeur après gravure : | 1.0 μm |
| Contrainte : | -1.2Gpa |
| **Couche intermédiaire 26 : oxyde de silicium Si02** | |
| Module de Young : | 75 GPa |
| Coefficient de Poisson : | 0.165 |
| Epaisseur : | 2 nm |
| Largeur après gravure : | 1.0 μm |
| **Couche de transport 24: silicium Si** | |
| Module de Young : | 170 GPa |

(suite)

| Couche de transport 24: silicium Si | |
|---|---|
| Coefficient de Poisson : | 0.278 |
| Epaisseur : | 20 nm |
| Largeur après gravure : | 1.0 µm |

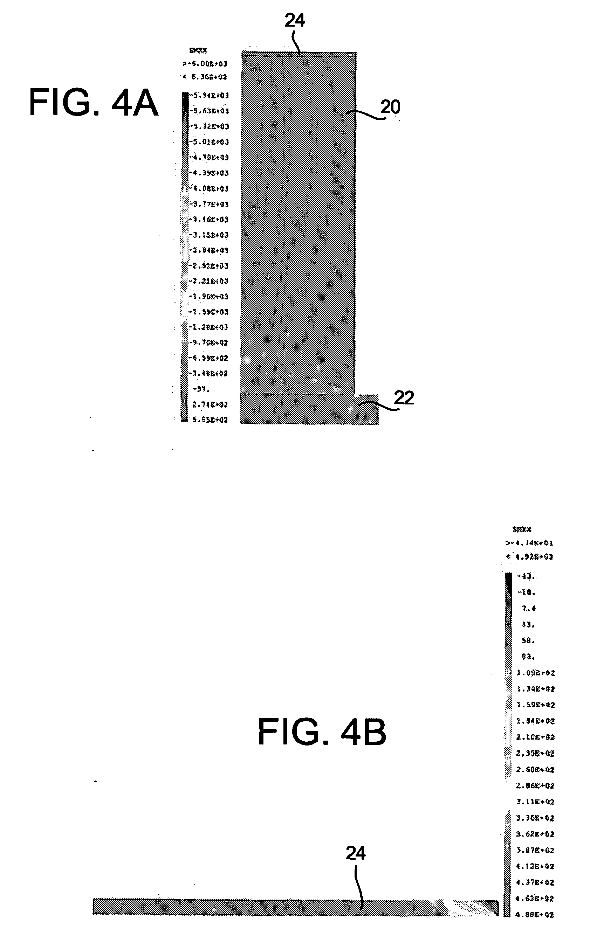

La figure 4A présente l'un des résultats obtenus : le terme $\sigma_{xx}$ du tenseur des contraintes (l'axe des X étant pris comme étant parallèle à la surface initiale de l'empilement technologique) y est représenté dans la masse des matériaux, suivant le code indiqué sur l'échelle de gauche (exprimée en MPa), et démontre le fait qu'il est possible de contraindre le canal en réalisant le procédé selon l'invention.

La figure 4B représente l'état de contrainte de la seule couche semi-conductrice 24 dans la masse des matériaux, suivant le code indiqué sur l'échelle de droite (exprimée en MPa).

Il apparaît sur ces schémas que, en son centre, la couche de transport est le lieu d'une contrainte en tension d'environ 500 MPa.

On peut d'ores et déjà proposer une valeur de la déformation maximale de la couche semi-conductrice.

En effet, en considérant que :

- la profondeur de gravure $h_g$ autorise la couche pré-contrainte 20 à être totalement relaxée au niveau de sa surface supérieure (la gravure étant effectuée sur une hauteur au moins égale à la largeur (= $l_{24}/2$ de la figure 3A) du motif défini,
- les couches 24 et 26 sont fines devant la hauteur gravée $h_g$ et la somme de leurs épaisseurs $\Sigma e_i$ est, elle-même, petite devant $h_g$, de sorte que la couche pré-contrainte 20 impose ses déformations aux couches 24 et 26,

alors : la déformation imposée à la couche 24 est égale à $-\varepsilon\sigma$, soit l'opposé de la déformation initiale $\varepsilon\sigma$ du film pré-contraint 20.

Cette valeur $-\varepsilon\sigma$ est la valeur maximale de la déformation que pourra atteindre le film 24, et, en déformation plane, elle correspondra donc à une contrainte maximale accessible égale à :

$$\sigma_{24}^{\text{max}} = -\frac{E_{24}}{1-V_{24}} x\, \varepsilon_1 \qquad (\text{eq. 1})$$

où $E_{24}$ et $V_{24}$ sont respectivement les modules de Young et coefficient de poisson du film semi-conducteur 24 et $\varepsilon_1$ est la déformation du film pré-contraint 20 avant les différentes étapes de gravure.

En utilisant la loi de Hook, cette contrainte maximale peut être exprimée en fonction de la contrainte à laquelle le film pré-contraint était soumis. Ceci conduit alors à:

$$\sigma_{24}^{\text{max}} = -\frac{E_{24}}{1-V_{24}} x - \frac{1-V_{20}}{E_{20}} x\, \sigma_{20} \qquad (\text{eq. 2})$$

où $E_{20}$ et $V_{20}$ sont respectivement les modules de Young et coefficient de poisson de la couche pré-contrainte 20 et $\sigma_{20}$ est la contrainte du film pré-contraint 20 avant les différentes étapes de gravure.

A partir de cette équation 2 et des valeurs numériques données dans le tableau I, on obtient une valeur maximale de la contrainte, dans le film semi-conducteur, égale à 498MPa (arrondie au MPa inférieur).

Ainsi, typiquement pour une grille de 100 nm d'un transistor NMOS, on peur prévoir une amélioration de la mobilité des électrons de 10% et, pour une grille de 10 µm, une amélioration de 20%.

Cette valeur de 498 MPa, obtenue par estimation analytique, est cohérente avec la valeur numérique obtenue par la méthode des éléments finis, égale à 492MPa (valeur extraite au centre du motif mince et arrondie au MPa inférieur).

Cette modélisation permet de mettre en évidence que la nature des matériaux intervient directement dans la valeur maximale de contrainte accessible dans le motif semi-conducteur 24, puisque cette valeur maximale est proportionnelle au rapport des modules élastiques $E_{24}/E_{20}$ comme indiqué dans l'équation 2 ci-dessus.

Si les hypothèses de travail sur les épaisseurs des différentes couches 24, 26 et la hauteur de gravure hg ne sont plus valables, la contrainte accessible peut être sensiblement différente de la valeur calculée via l'équation 2.

Si la largeur du motif mince semi-conducteur 24 est du même ordre de grandeur que son épaisseur, la contrainte accessible au centre de ce motif est alors affectée par la proximité des bords du motifs.

Sur ces bords, la contrainte normale est nulle pour respecter le fait que cette surface soit libre, par conséquent $\sigma_{xx}$ s'y annule.

La proximité de ces bords libres peut donc sensiblement diminuer la contrainte au centre du motif si la largeur du motif n'est pas grande devant son épaisseur.

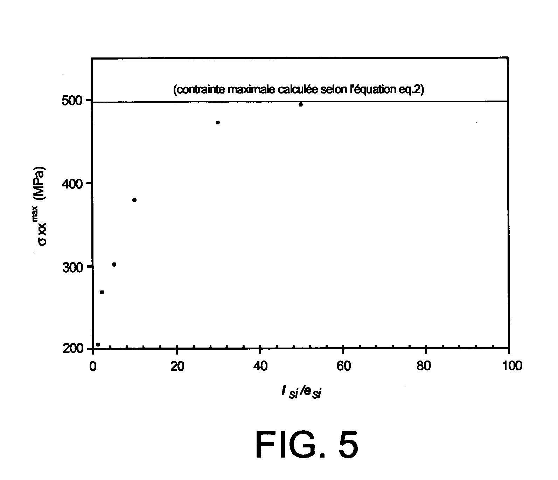

Ce propos est illustré sur la figure 5 sur laquelle est représentée l'évolution du maximum de la composante $\sigma_{xx}$ du tenseur des contraintes en fonction de la largeur $l_{24}$ du motif semi-conducteur 24, pour une épaisseur $e_{24}$ de ce même motif ou film fixée et égale à 20nm. Les valeurs des autres paramètres sont celles indiquées dans le tableau I. Les résultats présentés ont été obtenus à l'aide du code éléments finis CASTEM®.

On observe que, en deçà d'un facteur 10 du rapport $l_{24}/e_{24}$, la contrainte maximale dans la couche est déjà 20% plus faible que la valeur maximale estimée par l'approche analytique. Cette faible valeur est le fait de la faible distance entre le centre du motif, et les bords libres où la contrainte s'annule, par définition, et donc de la faible largeur du motif.

Cette modélisation analytique ne tient pas compte de l'effet, sur la contrainte du motif mince 24, de la profondeur hg, sur laquelle la couche pré-contrainte est gravée.

Pour modéliser cette contribution on utilise le code éléments finis CASTEM®.

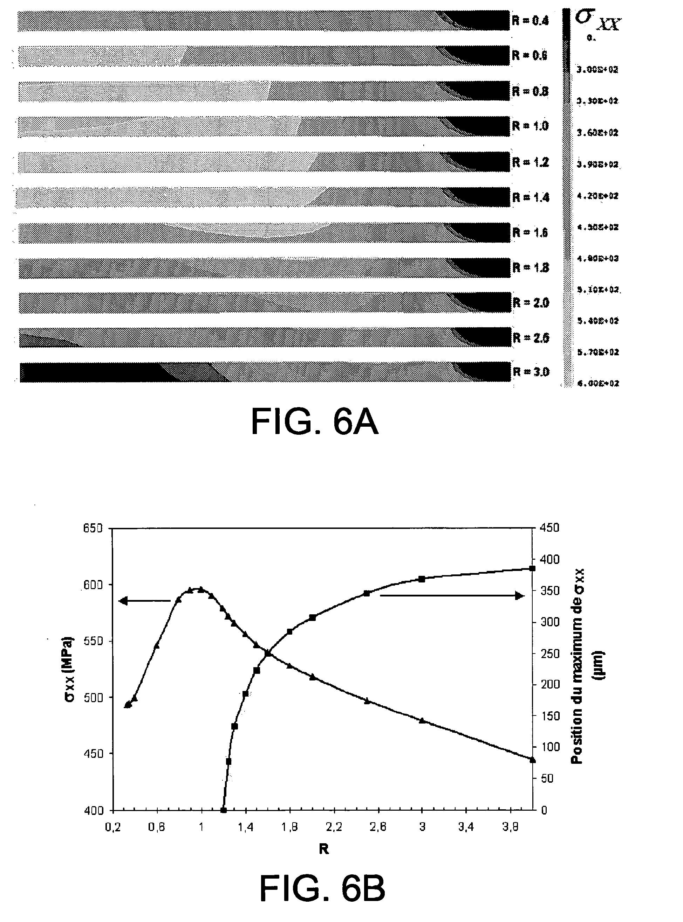

L'évolution de la contrainte $\sigma_{xx}$ dans le film mince 24, en fonction du rapport $R_2 = (l_{24}/h_g)$, est illustrée sur la figure 6A où seul $h_g$ a été modifié d'un calcul à un autre, tous les autres paramètres, y compris $e_{24}$, étant fixés par ailleurs aux valeurs présentées dans le tableau 1.

Est également représentée sur la figure 6B l'évolution du maximum de $\sigma_{xx}$ (échelle de gauche) et de sa position (comptée à partir du bord de motif, échelle de droite) en fonction de $R_2$. La contrainte $\sigma_{xx}$ est obtenue pour une hauteur gravée hg égale à la demi largeur $l_{24}/2$ du motif : dans une telle configuration, la singularité géométrique qu'est le pied de gravure engendre un état de contrainte qui renforce l'état de tension du motif mince en son centre. Le pied de gravure P (figure 7B) est un lieu de concentration de contrainte d'où part un lobe de contrainte induit par le phénomène dit de « pelage » qui tend à détacher le film contraint de son substrat. Ce lobe de contrainte au centre s'étend dans la masse du film gravé et peut venir renforcer de façon très significative l'état de contrainte au centre du motif mince, comme illustré sur les figures 6A et 6B.

Pour les faibles valeurs de R, qui correspondent aux fortes valeurs de $h_g$, on retrouve la valeur de 495MPa, qui valide l'approche analytique de l'équation 2 et, pour les fortes valeurs de R, c'est-à-dire pour les faibles valeurs de $h_g$, la contrainte passe bien en deçà de cette valeur de 495 MPa, car l'épaisseur gravée y est alors trop faible pour autoriser une relaxation complète de la couche pré-contrainte.

Ce comportement est parfaitement symétrique si la contrainte dans la couche pré-contrainte 20 est une contrainte de tension : les résultats ci-dessus ont alors exactement reproduits au signe près.

Un avantage important du procédé selon l'invention est de simplifier l'ensemble des 4 premières étapes décrites dans le brevet US 6,563,152 B2 en une unique gravure anisotrope de la couche précontrainte du substrat de départ.

Ceci permet en outre de parvenir au même résultat : contraindre le canal d'un transistor, ou plus généralement contraindre un motif mince.

Cette simplicité avantageuse du procédé selon l'invention est renforcée par le fait que les zones d'accès (source et drain) du transistor existent a priori dans la solution proposée. Il n'est donc pas besoin de venir les former à posteriori après avoir contraint le canal comme dans le document US6563152, ce qui évite des étapes technologiques supplémentaires.

Le motif étant contraint, il reste à former la grille selon l'enchaînement technologique suivant :

- remplissage des cavités 28 et 30, par exemple par un oxyde déposé,
- formation de l'oxyde de grille,
- formation et gravure de la grille,
- formation des espaceurs,
- implantation/diffusion des zones d'accès source et drain.

On obtient ainsi un transistor.

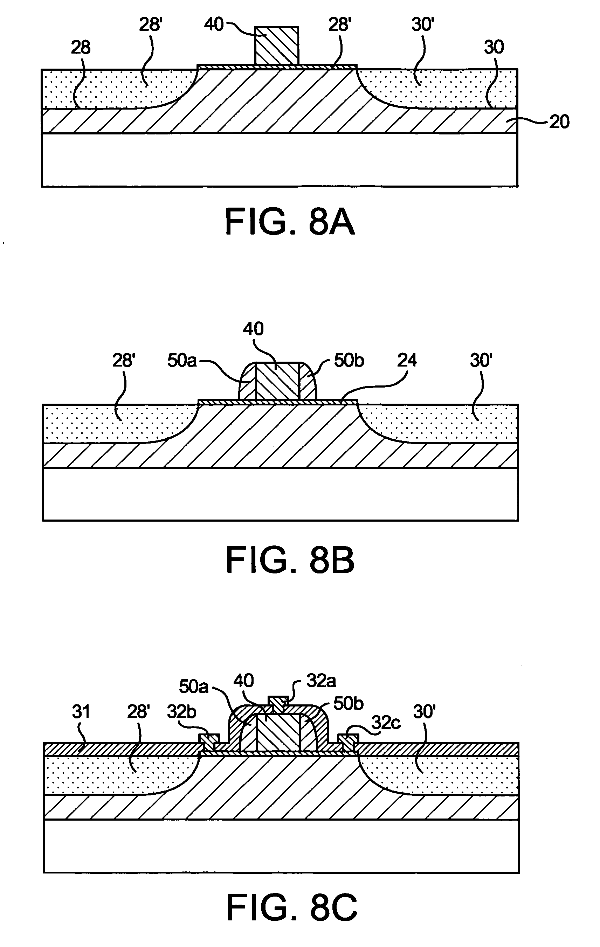

La réalisation d'un transistor va également être illustrée en liaison avec les figures 8A - 8C.

En reprenant les notations des figures 7A et 7B, le remplissage des tranchées 28 et 30 avec, respectivement, un matériau 28', 30', de préférence isolant, le dépôt de l'empilement de grille (schématisé en un seul et unique bloc 40 par soucis de simplification), puis sa gravure par des étapes standards de photolithographie et de gravure conduisent à la structure de la figure 8A, après le retrait de la résine photosensible.

En cet état une première implantation, dite LDD, est généralement mise en oeuvre.

Le remplissage des tranchées est préférentiellement réalisé par un matériau isolant et/ou qui renforce l'état de déformation du film mince 24, imposé ou augmenté par la relaxation latérale de couche 20.

La formation d'espaceurs 50a, 50b (figure 8B) comporte généralement un dépôt d'oxyde ($SiO_2$), puis de nitrure ($Si_3N_4$), cet empilement étant ensuite gravé par gravure anisotrope en laissant un cordon isolant sur les flans la de grille, cordons qui forment lesdits espaceurs.

En cet état, l'implantation des sources et drains est généralement réalisée et une étape, dite de nitruration, éventuellement précédée d'une épitaxie sélective des sources et drains, permet de réduire les résistances d'accès à la source, au drain et à la grille par formation d'un alliage (par exemple NiSi) en surface de ces différentes zones.

Le composant formé peut ensuite être encapsulé dans une couche électriquement isolante 31, à travers laquelle des vias (perforations locales de la couche d'encapsulation) sont formés puis remplis par un métal (par exemple : Cu) pour remonter des prises de contact électrique 32a, 32b et 32c au niveau de la surface supérieure de la couche d'encapsulation (figure 8C).

Le composant à canal contraint ainsi formé est alors fonctionnel.

**Revendications**

1. Procédé permettant contraindre ou déformer un motif ou une couche mince (24), ou pour augmenter une contrainte ou une déformation de ce motif ou de cette couche mince, à partir d'un composant initial comportant ledit motif ou ladite couche mince et une couche précontrainte (20), ce procédé comportant :

   - une étape de relaxation de la contrainte initiale de la couche précontrainte par gravure de la couche précontrainte, sur une partie seulement de son épaisseur.

2. Procédé selon la revendication 1, la couche pré-contrainte étant électriquement isolante, par exemple en $Si_3N_4$.

3. Procédé selon l'une des revendications 1 ou 2, le composant initial comportant en outre une ou plusieurs couches (26 - i) intercalées entre le motif ou la couche mince, et la couche pré-contrainte.

4. Procédé selon la revendication 3, la somme des épaisseurs des couches intercalées (26-i) et de l'épaisseur du motif ou de la couche mince (24) étant faible devant l'épaisseur gravée de la couche pré-contrainte (20).

5. Procédé selon l'une des revendications 1 à 4, la couche précontrainte (20) du composant initial reposant sur un substrat (22).

6. Procédé selon la revendication 5, l'épaisseur de la couche précontrainte (20) avant gravure étant faible devant l'épaisseur du substrat (22).

7. Procédé selon l'une des revendications 5 ou 6, une couche tampon (23) ou de tenue mécanique étant disposée entre la couche précontrainte et le substrat (22).

8. Procédé selon la revendication 7, la couche tampon étant en $SiO_2$.

9. Procédé selon l'une des revendications 1 à 8, la gravure de la couche précontrainte (20) conduisant à la formation de cavités latérales (28, 30) dans cette couche.

10. Procédé selon la revendication 9, les cavités latérales étant ensuite comblées par un matériau.

11. Procédé selon la revendication 10, ledit matériau utilisé pour combler les cavités latérales présentant lui même un état de contrainte.

12. Procédé selon la revendication 11, l'état de contrainte dudit matériau renforçant l'état de contrainte du motif ou de la couche mince (24) résultant de la gravure et de la relaxation de la couche pré-contrainte (20).

13. Procédé de formation d'un transistor, comportant un procédé pour contraindre un motif ou une couche mince selon l'une des revendications 10 à 12, ainsi que des étapes :

    - de formation d'oxyde de grille,

- de formation et de gravure d'une grille,
- de formation d'espaceurs,
- d'implantation ou de diffusion de zones d'accès source et drain.

**Claims**

1. Method enabling a stress or a deformation in a pattern or a thin layer (24) or enabling increasing a stress or a deformation starting from an initial component comprising the said pattern or thin layer and a prestressed layer (20), this method comprising:

   - a step of relaxing the initial stress of the prestressed layer through etching of the prestressed layer through only part of its thickness.

2. Method according to claim 1, the prestressed layer being electrically insulating, for example made of $Si_3N_4$.

3. Method according to one of claims 1 or 2, the initial component comprising also one or several layers (26 - i) inserted between the pattern or the thin layer, and the prestressed layer.

4. Method according to claim 3, the sum of the thicknesses of the intermediate layers (26-i) and the thickness of the pattern or the thin layer (24) being small compared with the etched thickness of the prestressed layer (20).

5. Method according to one of claims 1 to 4, the prestressed layer (20) of the initial component lying on a substrate (22).

6. Method according to claim 5, the thickness of the prestressed layer (20) before etching being small compared with the thickness of the substrate (22).

7. Method according to one of claims 5 or 6, a buffer layer (23) or a mechanical resistance layer being placed between the prestressed layer and the substrate (22).

8. Method according to claim 7, the buffer layer being made of $SiO_2$.

9. Method according to one of claims 1 to 8, etching of the prestressed layer (20) leading to the formation of lateral cavities (28, 30) in this layer.

10. Method according to claim 9, the lateral cavities then being filled in with a material.

11. Method according to claim 10, the said material used to fill in the lateral cavities being itself in a stressed state.

12. Method according to claim 11, the stressed state of the said material reinforcing the state of stress of the pattern or the thin layer (24) resulting from etching and relaxation of the prestressed layer (20).

13. Method of forming a transistor, comprising a method for straining a pattern or a thin layer according to one of claims 13 to 15, and steps:

   - to form the gate oxide,
   - to form and etch the gate,
   - to form spacers,
   - implantation or diffusion of source and drain access areas.

**Patentansprüche**

1. Verfahren, welches die Beaufschlagung eines Motivs bzw. Musters oder einer dünnen Schicht (24) mit einer Beanspruchung bzw. einer Spannung oder die Verformung eines Motivs oder einer dünnen Schicht gestattet oder die Erhöhung einer Beanspruchungsbeaufschlagung oder einer Verformung dieses Motivs oder dieser Dünnschicht, ausgehend von einem anfänglichen oder Ausgangs-Bauteil, welches das genannte Motiv oder die genannte dünne Schicht sowie eine vorgespannte Schicht (20) umfasst, wobei das Verfahren umfaßt:

- eine Verfahrensstufe der Relaxation der anfänglichen Spannung der vorgespannten Schicht mittels Ätzung der vorgespannten Schicht nur über einen Teil ihrer Dicke.

2. Verfahren nach Anspruch 1, bei welchem die vorgespannte Schicht elektrisch isolierend ist, und beispielsweise aus $Si_3N_4$ besteht.

3. Verfahren nach einem der Ansprüche 1 oder 2, bei welchem das Ausgangsbauteil des weiteren eine oder mehrere, zwischen dem Motiv oder der Dünnschicht und der vorgespannten Schicht angeordnete Zwischenschicht(en) (26 - i) aufweist.

4. Verfahren nach Anspruch 3, bei welchem die Summe der Dicken der zwischengeschalteten Schichten (26 - i) und der Dicke des Motivs oder der dünnen Schicht (24) klein im Vergleich zur geätzten Dicke der vorgespannten Schicht (20) ist.

5. Verfahren nach einem der Ansprüche 1 bis 4, bei welchem die vorgespannte Schicht (20) des Ausgangsbauteils auf einem Substrat (22) ruht.

6. Verfahren nach Anspruch 5, bei welchem die Dicke der vorgespannten Schicht (20) vor dem Ätzen klein im Vergleich zur Dicke des Substrats (22) ist.

7. Verfahren nach einem der Ansprüche 5 oder 6, bei welchem zwischen der vorgespannten Schicht und dem Substrat (22) eine Tampon- oder Pufferschicht bzw. eine Schicht zur festen Maßhaltigkeit angeordnet ist.

8. Verfahren nach Anspruch 7, bei welchem die Tamponschicht aus $SiO_2$ besteht.

9. Verfahren nach einem der Ansprüche 1 bis 8, bei welchem die Ätzung der vorgespannten Schicht (20) zur Bildung von seitlichen Ausnehmungen bzw. Hohlräumen (28, 30) in dieser Schicht führt.

10. Verfahren nach Anspruch 9, bei welchem die seitlichen Ausnehmungen bzw. Hohlräume danach mit einem Material ausgefüllt werden.

11. Verfahren nach Anspruch 10, bei welchem das zum Ausfüllen der seitlichen Ausnehmungen bzw. Hohlräume verwendete Material seinerseits selbst einen Spannungszustand aufweist.

12. Verfahren nach Anspruch 11, bei welchem der Spannungszustand des genannten Materials den aus der Ätzung des Motivs oder der dünnen Schicht und der Relaxation der vorgespannten Schicht (20) resultierenden Spannungszustand des Motivs oder der Dünnschicht (24) verstärkt.

13. Verfahren zur Ausbildung eines Transistors, welches ein Verfahren zur Spannungsbeaufschlagung eines Motivs oder einer Dünnschicht nach einem der Ansprüche 10 bis 12 umfasst, sowie die Verfahrensstufen:

   - Ausbilden eines Gate-Oxyds,
   - Ausbilden und Ätzen eines Gates,
   - Ausbilden von Abstandshaltern,
   - Implantation oder Diffundieren von Source- und Drainzugangszonen.

## FIG. 1

## FIG. 2

I$_{24}$

26  24

20

22

## FIG. 3A

26  24

20

22

## FIG. 3B

28  26  24  30

20

22

## FIG. 3C

FIG. 4A

FIG. 4B

FIG. 5

FIG. 6A

FIG. 6B

28  30

## FIG. 7A

28  P  30

## FIG. 7B

FIG. 8A

FIG. 8B

FIG. 8C

**EP 1 615 271 B1**

## RÉFÉRENCES CITÉES DANS LA DESCRIPTION

**Documents brevets cités dans la description**

- US 6563152 B

- US 6563152 B2

**Littérature non-brevet citée dans la description**

- **O. RAYSSAC.** SOI Technology and Devices. *Electro-Chemical Society Proceedings,* 2001, vol. 39